# EUROPEAN PATENT SPECIFICATION

(11) **EP 3 760 959 B1**
(45) Date of publication and mention of the grant of the patent: **19.07.2023**
(21) Application number: 20181545.3
(22) Date of filing: 23.06.2020
(51) Int. Cl.: F28D 15/02

(54) **HEAT DISSIPATION DEVICE**
WÄRMEABLEITUNGSVORRICHTUNG
DISPOSITIF DE DISSIPATION DE CHALEUR

(30) Priority: 03.07.2019 TW 108208638 U
(43) Date of publication of application: 06.01.2021
(73) Proprietor: Giga-Byte Technology Co., Ltd., New Taipei City 231 (TW)
(72) Inventor: HUANG, Shun-Chih, 231 New Taipei City (TW); MAO, Tai-Chuan, 231 New Taipei City (TW); GUO, Chun-Liang, 231 New Taipei City (TW)
(74) Representative: Becker, Eberhard

(56) References cited:
- WO-A1-2013/166933
- CN-U- 210 579 811
- US-A1- 2010 142 147
- US-A1- 2014 110 090
- US-A1- 2019 072 334
- US-A1- 2019 093 963

## Description

### BACKGROUND

### Technical Field

The invention relates to a heat dissipation device, and in particular to a heat dissipation device capable of dissipating heat from a plurality of heat sources.

### Description of Related Art

In general, a water cooling head heat dissipation device is often disposed on a circuit board to dissipate heat from a heat source on the circuit board. The common water cooling head heat dissipation devices may be categorized into closed water cooling structures and open water cooling structures; in either structure, a part of the water cooling head heat dissipation device is usually thermally coupled to the heat source, and the heat of the heat source is transmitted to heat dissipation fins through liquid, so as to dissipate the heat energy.

Nowadays, computer devices have been developed to achieve high performance and occupy small size, and there are usually plural heat sources on a circuit board. In view of the above, how to dissipate heat from plural heat sources simultaneously and improve the overall heat dissipation effects with use of a simple device occupying small space has become an issue that requires prompt resolution.
US 2019/093963 A1 discloses a water-cooling heat dissipating system including a pump and a water-cooling head. The water-cooling head includes a base, a first chamber and a second chamber. The base is in contact with an electronic component. The first chamber and the second chamber are located over the base and separated from each other. The first chamber includes a first inlet and a first outlet. The first inlet is in fluid communication with the pump. The second chamber includes a second inlet and a second outlet. The second inlet is fluid communication with the first outlet. The liquid continuously flows through the first chamber and the second chamber. The heat from the electronic component is transferred to the liquid within the first chamber and the second chamber through the base, and released through the first outlet and the second outlet.

### SUMMARY OF THE INVENTION

The invention provides a heat dissipation device capable of dissipating heat from plural heat sources according to the appended claims. The following disclosure serves a better understanding of the present invention.

The heat dissipation device provided in an embodiment of the invention is adapted to be disposed on a primary heat source and a secondary heat source. The heat dissipation device includes a water cooling head module and a heat conducting member. The water cooling head module is disposed on the primary heat source. The heat conducting member is thermally coupled to the secondary heat source and extends into the water cooling head module.

In an embodiment of the invention, the water cooling head module has a water cooling tank and a plurality of fins. The fins extend along a first direction and are arranged in parallel along a second direction in the water cooling tank. The fins sleeve on one portion of the heat conducting member in the second direction.

In an embodiment of the invention, the heat conducting member includes a heat pipe.

In an embodiment of the invention, the water cooling head module has a water cooling tank, a water inlet, a water outlet, and a plurality of fins. The water inlet and the water outlet respectively communicate with the water cooling tank. The fins extend along the first direction and are arranged in parallel along the second direction in the water cooling tank. The water cooling head module includes at least one side wall and at least one inner partition board. The at least one side wall extends along the first direction and is located on at least one side of fin, and the at least one inner partition board extends along the second direction and is connected to the at least one side wall and at least one outermost fin of the fins.

In an embodiment of the invention, the at least one side wall includes two side walls, and the at least one inner partition board includes two inner partition boards. The two side walls extend along the first direction and are located at both sides of the fins, and the two inner partition boards extend along the second direction and are connected to two outermost fins of the fins. The water inlet is located at one side of a line connecting the two side walls, and the water outlet is located at the other side of the line connecting the two side walls.

In an embodiment of the invention, the water cooling head module has a water cooling tank, a water inlet, a water outlet, and a plurality of fins. The water cooling tank includes a first region and a second region. The water inlet is connected to the first region, and the water outlet is connected to the second region. The fins extend from the first region to the second region. The heat conducting member has a first terminal, a second terminal opposite to the first terminal, and a middle segment located between the first terminal and the second terminal. The middle segment is thermally coupled to the secondary heat source, the first terminal extends into and communicates with the first region of the water cooling tank, and the second terminal extends into and communicates with the second region of the water cooling tank.

In an embodiment of the invention, the heat conducting member is a runner pipe, and an inner diameter of the first terminal of the runner pipe is greater than an inner diameter of the second terminal.

In an embodiment of the invention, the heat dissipation device further includes a heat sink disposed on the secondary heat source, and the heat conducting member is thermally coupled to the secondary heat source through the heat sink.

In an embodiment of the invention, the water cooling head module further includes a bottom plate disposed on the primary heat source, and the heat conducting member contacts the bottom plate.

In an embodiment of the invention, the water cooling head module further includes a bottom plate disposed on the primary heat source, and the heat conducting member is suspended from the bottom plate.

Based on the above, the heat dissipation device provided in one or more embodiments of the invention includes the water cooling head module and the heat conducting member. The water cooling head module is thermally coupled to the primary heat source, one portion of the heat conducting member extends into the water cooling head module, and the other portion is thermally coupled to the secondary heat source. Thereby, the heat dissipation device provided in one or more embodiments of the invention dissipates heat from plural heat sources at the same time with use of one water cooling head module. In other words, the heat dissipation device provided in one or more embodiments of the invention may achieve heat dissipation effects within a limited space in a more efficient manner and may be more extensively applied..

### BRIEF DESCRIPTION OF THE DRAWINGS

FIG. 1A is a schematic assembly view illustrating that a heat dissipation device disposed on a circuit board according to an embodiment of the invention.
FIG. 1B is a schematic top view illustrating that the heat dissipation device in FIG. 1A is disposed on a circuit board.
FIG. 1C is a schematic view illustrating that the heat dissipation device in FIG. 1A is disposed on a circuit board at another view angle.
FIG. 1D is a schematic partial cross-sectional view illustrating that the heat dissipation device in FIG. 1A is disposed on a circuit board along a sectional line A-A'.
FIG. 2 is a schematic view illustrating that a heat dissipation device is disposed on a circuit board according to another embodiment of the invention.
FIG. 3 is a schematic top view illustrating that a heat dissipation device is disposed on a circuit board according to yet another embodiment of the invention.

### DESCRIPTION OF THE EMBODIMENTS

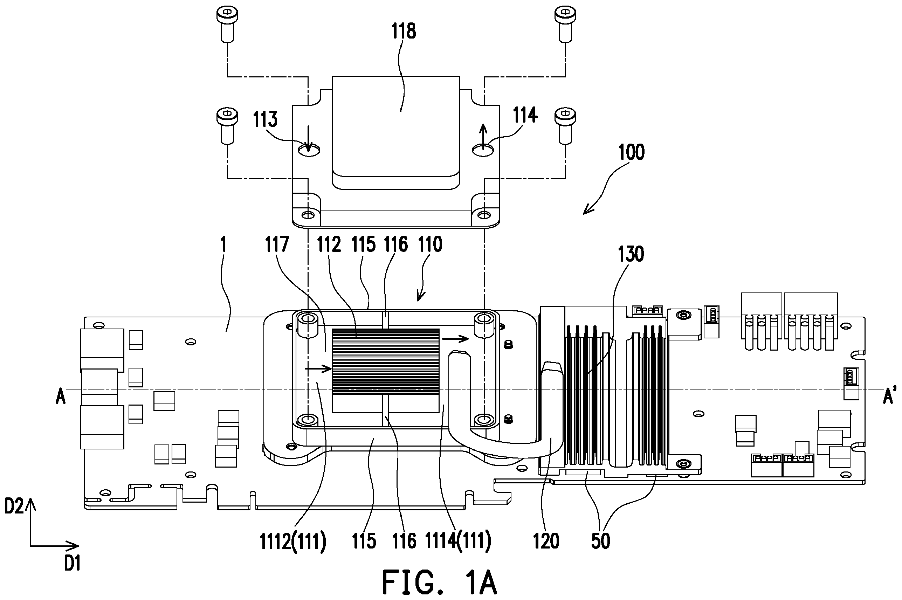

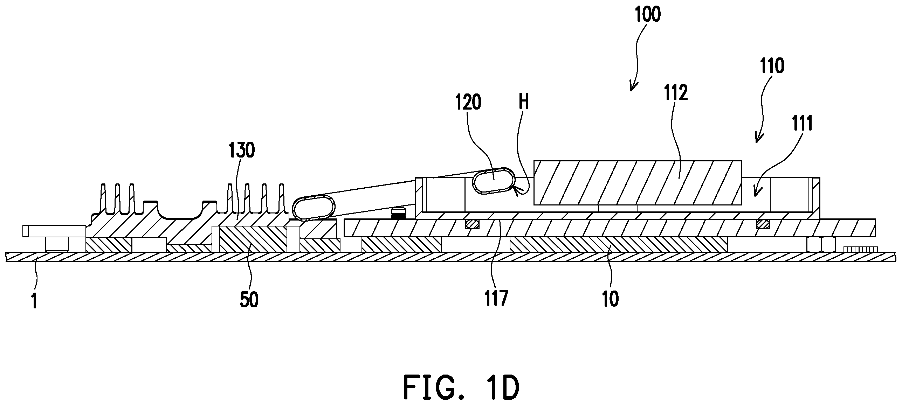

FIG. 1A is a schematic assembly view illustrating that a heat dissipation device disposed on a circuit board according to an embodiment of the invention. With reference to FIG. 1A, in the embodiment, a heat dissipation device 100 is adapted to be disposed on a primary heat source 10 (FIG. 1D) and a secondary heat source 50 and is configured to dissipate heat from the primary heat source 10 and the secondary heat source 50. According to the embodiment, note that the number of the primary heat source 10 shown in the drawings is one, for instance, and the number of the secondary heat source 50 shown in the drawings is plural; however, the number of the primary heat source 10 and the secondary heat source 50 should not be construed as a limitation in the invention.

It is worth mentioning that the heat dissipation device 100 provided in the invention is disposed on the circuit board 1 and is responsible for dissipating heat from the primary heat source 10 and the secondary heat source 50 on the circuit board 1. In the embodiment, the circuit board 1 is an expansion card, for instance, the primary heat source 10 is, for instance, a graphics processing unit (GPU), and the secondary heat source 50 is, for instance, a metal-oxide-semiconductor field-effect transistor (MOSFET) chip. Certainly, the heat source providing the heat dissipated by the heat dissipation device 100 is not limited in the invention, and the circuit board 1 may also be a motherboard. In addition, in order to clearly describe the internal structure of the heat dissipation device 100 of the invention, except for FIG. 1A, the structure of an upper cover 118 is omitted from the other figures.

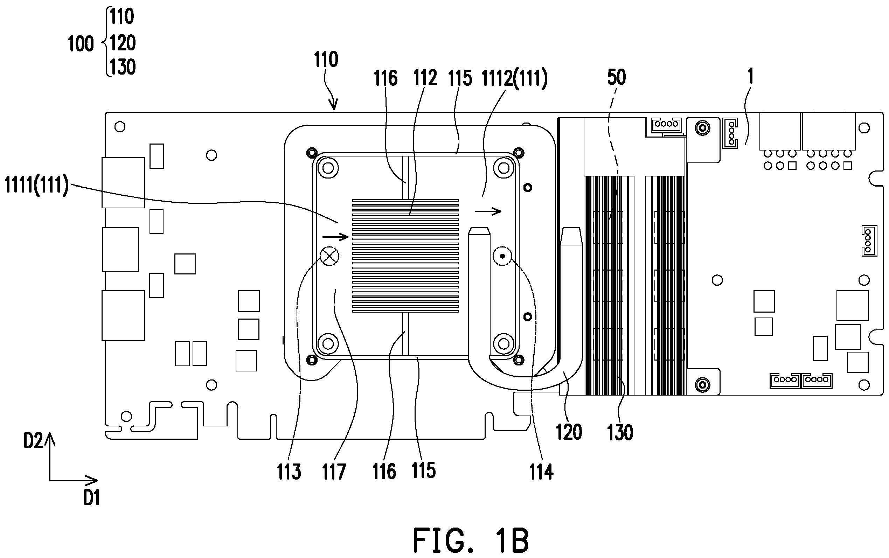

FIG. 1B is a schematic top view illustrating that the heat dissipation device in FIG. 1A is disposed on a circuit board. With reference to FIG. 1A and FIG. 1B, in the embodiment, the heat dissipation device 100 includes a water cooling head module 110 and a heat conducting member 120. The water cooling head module 110 is disposed on the primary heat source 10, one portion of the heat conducting member 120 extends into the water cooling head module 110, and the other portion is thermally coupled to the secondary heat source 50 on the circuit board 1. Further, the primary heat source 10 provided in the embodiment is thermally coupled to the water cooling head module 110. Therefore, the heat energy generated by the primary heat source 10 is directly exported through the water cooling head module 110. In addition, the heat energy generated by the secondary heat source 50 provided in the embodiment may also be transmitted to the water cooling head module 110 through the heat conducting member 120 in a thermally conductive manner and also exported through the water cooling head module 110.

In view of said design, the heat dissipation device provided in the embodiment 100 may achieve the overall heat dissipation of the circuit board 1 through one water cooling head module 110. That is, the heat dissipation device 100 provided in the embodiment may simultaneously dissipate the heat from the primary heat source 10 (CPU) and the secondary heat source 50 (other components) in no need of occupying too much space.

Besides, as shown in FIG. 1A and FIG. 1B, the heat dissipation device provided in the embodiment 100 may also be equipped with a heat sink 130 on the secondary heat source 50, and the heat conducting member 120 is thermally coupled to the secondary heat source 50 through the heat sink 130. This design allows the heat sink 130 to simultaneously perform the heat conduction function and the function of dissipating the heat energy from the secondary heat source 50 to the air. Certainly, the type and the form of the heat sink are not limited in the invention, and it is not required for the secondary heat source 50 to have the heat sink 130 thereon. Alternatively, the heat sink 130 may be partially disposed on the secondary heat source 50, or the heat conducting member 120 may be directly thermally coupled to the secondary heat source 50.

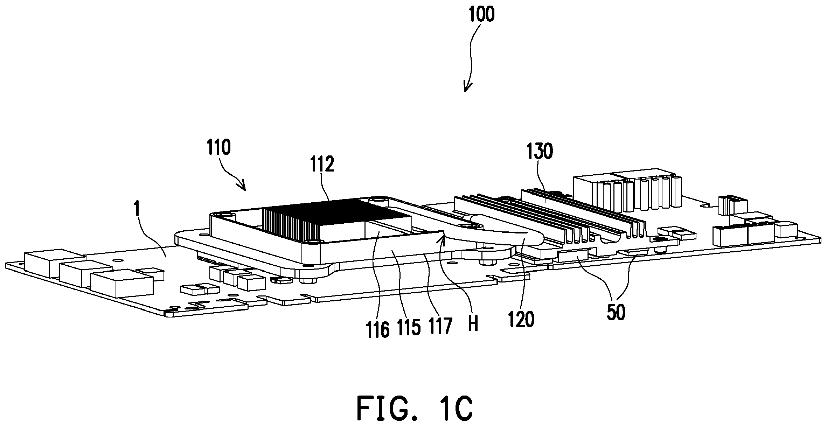

As shown in FIG. 1A and FIG. 1B, the water cooling head module provided in the embodiment 110 has a water cooling tank 111, and the water cooling tank 111 includes the upper cover 118 (FIG. 1A). In detail, the water cooling tank 111 has an opening H (FIG. 1C) corresponding to the outer contour of the heat conducting member 120, and the shape of the heat conducting member 120 is a U shape according to the embodiment. Further, one section of the U-shaped heat conducting member 120 extends into the water cooling tank 111 through the opening H, and the other corresponding section of the U-shaped heat conducting member 120 is thermally coupled to the secondary heat source 50. Certainly, the shape of the heat conducting member 120 should not be construed as a limitation in the invention.

Further, in the present embodiment, there may be heat dissipation fluid inside the water cooling tank 111, for instance. Hence, an O-ring (not shown) is further disposed between the inner wall of the opening H (FIG. 1C) and the heat conducting member 120 of the embodiment to prevent leakage of the heat dissipation fluid. Certainly, the form of the O-ring is not limited in the invention; in other embodiments, other forms of anti-leakage structures or components may also be selected, and the invention is not limited thereto. According to the embodiment, although there is the heat dissipation fluid in the liquid form inside the water cooling tank 111, for instance, in other embodiments, the heat dissipation fluid may be two-phase fluid or other heat dissipation media in other non-liquid form. The type of the heat dissipation medium is not limited in the invention.

According to the embodiment, the heat conducting member 120 is a heat pipe. In detail, the heat pipe (the heat conducting member 120) is a closed cavity (not shown) containing two-phase fluid and dissipates heat through convection by the liquid and vapor changes of the two-phase fluid. Certainly, the form of the heat conducting member 120 is not limited in the invention.

Further, in the embodiment, the water cooling head module 110 includes a plurality of fins 112 disposed in the water cooling tank 111, and the fins 112 extend along a first direction D1 and are arranged in parallel along a second direction D2 on a bottom plate 117 of the water cooling tank 111. The bottom plate 117 of the water cooling tank 111 is coupled to the primary heat source 10. In the embodiment, the heat pipe is disposed beside the fins 112 and spaced apart from the fins 112 by a distance. Certainly, in other embodiments, the heat pipe may be adhered to the fins, or the fins 112 sleeve on the heat pipe, which should however not be construed as a limitation in the invention. Besides, in other embodiments, the arrangement manner of the fins 112 is not limited in the invention.

As shown in FIG. 1A and FIG. 1B, the water cooling head module 110 provided in the embodiment has a water outlet 114 and a water inlet 113 communicating with the water cooling tank 111. In FIG. 1, the water outlet 114 and the water inlet 113 provided in the embodiment are disposed at the upper cover 118 of the water cooling head module 110, and the heat dissipation fluid flows into and out of the water cooling tank 111 in a direction perpendicular to the upper cover 118. Certainly, the form and the location of the water outlet 114 and the water inlet 113 are not limited in the invention. In other embodiments, the water outlet 114 and the water inlet 113 may also be disposed on a side of the water cooling tank 111 or may be designed in other appropriate manner, which should not be construed as a limitation in the invention.

In detail, as shown in FIG. 1B, in the embodiment, the water cooling head module 110 includes at least one side wall 115 and at least one inner partition board 116. For instance, in the embodiment, the number of the side walls 115 is four, and the number of the inner partition boards 116 is two. Two of the four side walls 115 extend along the first direction D1 and are located at opposite sides of the fins 112, and the two inner partition boards 116 extend along the second direction D2 and are connected to the two side walls 115 and two outermost fins of the fins 112. In addition, the water inlet 113 is located at one side of a line connecting the two side walls 115, and the water outlet 114 is located at the other side of the line.

Further, in the embodiment, the water cooling tank 111 includes a first region 1112 and a second region 1114. Specifically, the water inlet 113 communicates with the first region 1112, and the water outlet 114 communicates with the second region 1114. The first region 1112 and the second region 1114 are partitioned by the inner partition board 116, and the fins 112 extend from the first region 1112 to the second region 1114. Thereby, the heat dissipation fluid flows into the first region 1112 through the water inlet 113, flows into the second region 1114 through the fins 112, and then flows out of the water outlet 114.

Certainly, in other embodiments, the inner partition boards 116 may also be disposed at other locations, or the water cooling tank 111 may be equipped with one or no inner partition board 116. For instance, in an embodiment, one side of the fins 112 may directly lean against one of the side walls 115, and the inner partition boards 116 are connected to the other side (the outermost side) of the fins 112 and the corresponding side walls 115.

Alternatively, in another embodiment, the fins 112 may also be arranged in parallel from one of the side walls 115 (e.g., the side wall 115 on the upper portion of FIG. 1B) to the other side wall 115 (e.g., the side wall 115 on the lower portion of FIG. 1B) along the second direction D2, the water outlet 114 and the water inlet 113 are arranged along the first direction D1 at both terminals of the fins 112. Thereby, the water cooling head module 110 does not need to be equipped with any inner partition board 116, and the heat dissipation fluid may still flow through the fins 112. Certainly, the invention is not limited thereto, given that the fluid can flow toward the water outlet 114 through the fins 112 to ensure the good heat dissipation effects. Moreover, the number of the side walls 115, the number of the inner partition boards 116, the location of the inner partition boards 116, and the location of the fins 112 are not limited in the invention.

FIG. 1C is a schematic view illustrating that the heat dissipation device in FIG. 1A is disposed on a circuit board at another view angle. FIG. 1D is a schematic partial cross-sectional view illustrating that the heat dissipation device in FIG. 1A is disposed on a circuit board along a sectional line A-A'. As shown in FIG. 1C and FIG. 1D, the opening H of the water cooling tank 111 in the embodiment is higher than the bottom plate 117 of the water cooling tank 111. In other words, there is a certain distance between the edge of the opening H and the bottom plate 117. Hence, when the heat conducting member 120 is disposed on the opening H, the heat conducting member 120 is suspended from the bottom plate 117. As such, the heat dissipation fluid may flow through the bottom surface of the heat conducting member 120, so as to increase the heat dissipation efficiency. Certainly, in other embodiments, the heat conducting member 120 may also directly contact the bottom plate 117, and the relative location of the heat conducting member 120 and the bottom plate 117 is not limited in the invention.

According to the embodiment, it is worth mentioning that the water cooling head module 110 of the heat dissipation device 100 may adopt a standard design, and the shape and the length of the heat conducting member 120 may be adjusted according to the location of the secondary heat source 50 generated heat to be dissipated by the heat conducting member 120. Designers may select a specific heat conducting member 120 matching the water cooling head module 110 of uniform size according to the location of the secondary heat source 50 on different circuit boards 1. As such, the heat dissipation device 100 can have a good cost-performance ratio, and it is not necessary to make mold to produce specific heat dissipation device 100 tailored for the corresponding circuit board 1.

Other embodiments are provided below for explanation. The same or similar structural configurations, design principles, and technical effects in each embodiment are not further explained, but the design differences between the embodiments will be mainly described.

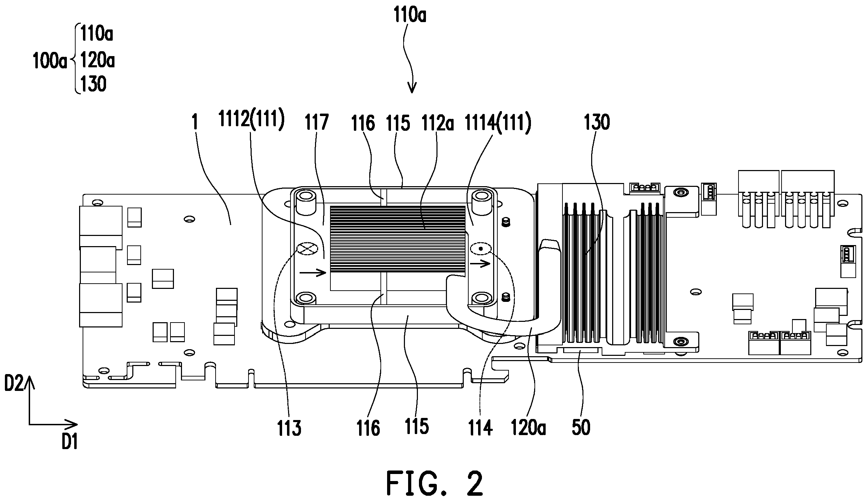

FIG. 2 is a schematic view illustrating that a heat dissipation device is disposed on a circuit board according to another embodiment of the invention. With reference to FIG. 2, the main difference between the heat dissipation device 100a provided in the embodiment and the heat dissipation device 100 provided in the previous embodiment lies in that in the fins 112a of the water cooling head module 110a sleeve on one portion of the heat conducting member 120a (the heat pipe) along the second direction D2. As such, when the heat dissipation fluid flows through the fins 112a, most of the heat dissipation fluid inevitably flows through the heat conducting member 120a, so that the conduction efficiency of the heat conducting member 120a may be increased.

Note that that some of the fins 112a on the right side (in the direction of FIG. 2) may sleeve on the heat conducting member 120a shown in FIG. 2. Certainly, in other embodiments, the fins 112 (in the direction of FIG. 2) in the middle or on the left side may sleeve on the heat conducting member 120, which should not be construed as a limitation in the invention.

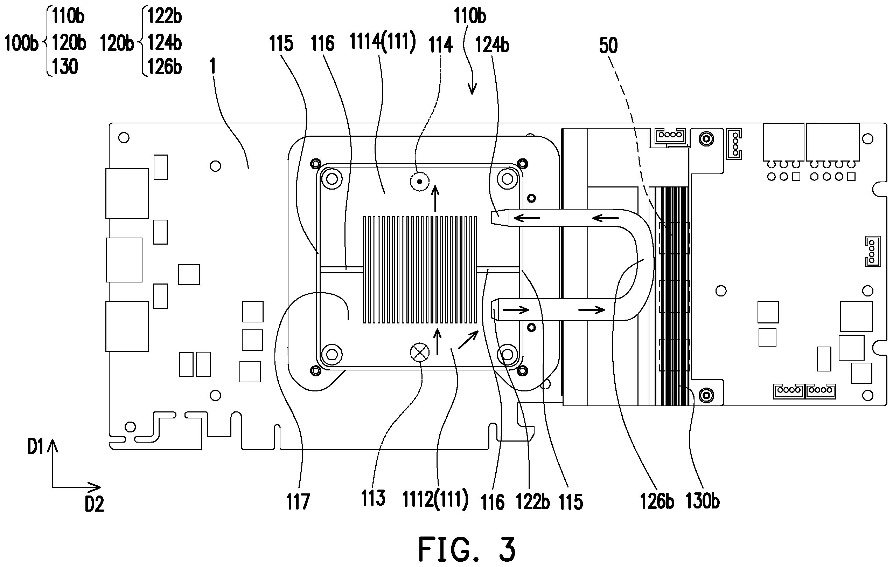

FIG. 3 is a schematic top view illustrating that a heat dissipation device is disposed on a circuit board according to yet another embodiment of the invention. With reference to FIG. 3, the main difference between the heat dissipation device provided in the embodiment 100b and the heat dissipation device provided in the previous embodiment lies in that the heat conducting member 120b in the embodiment is a hollow runner pipe. That is, the heat dissipation fluid in the water cooling tank 111b of the water cooling head module 110b provided in the embodiment may be circulated in the heat conducting member (the runner pipe) 120b and the water cooling tank 111b.

In detail, according to the embodiment, the heat conducting member 120b (the runner pipe) has a first terminal 122b, a second terminal 124b opposite to the first terminal 122b, and a middle segment 126b located between the first terminal 122b and the second terminal 124b. Further, the middle segment 126b of the heat conducting member 120b (the runner pipe) is thermally coupled to the secondary heat source 50, the first terminal 122b of the heat conducting member 120b (the runner pipe) extends into and communicates with the first region 1112 of the water cooling tank 111, and the second terminal 124b extends into and communicates with the second region 1114 of the water cooling tank 111. Thereby, the heat dissipation fluid may flow from the first region 1112 into the first terminal 122b of the heat conducting member 120b (the runner pipe) through the middle segment 126b and then flow from the second terminal 124b to the second region 1114, so as to bring the heat of the secondary heat source 50 to the second region 1114 of the water cooling tank 111b.

Moreover, in the embodiment, an inner diameter of the first terminal 122b of the heat conducting member 120b (the runner pipe) is larger than an inner diameter of the second terminal 124b. As shown in FIG. 3, the inner diameter of the heat conducting member 120b (the runner pipe) extending from the first terminal 122b to the middle segment 126b thermally coupled the secondary heat source 50 is greater than the inner diameter of the heat conducting member 120b (the runner pipe) extending from the middle segment 126b thermally coupled to the secondary heat source 50 to the second terminal 124b. Thereby, the flow resistance of the first terminal 122b of the heat conducting member 120b (the runner pipe) may be smaller than the flow resistance of the second terminal 124b, so that the flow direction of the heat dissipation fluid is from the first region 1112 to the second region 1114, thereby preventing the heat dissipation fluid from flowing back and affecting the heat dissipation efficiency. Through the design of the hollow pipe, the heat conducting member 120b (the runner pipe) provided in the embodiment allows the heat dissipation fluid to flow through a wider region, so as to efficiently dissipate the heat generated by the primary heat source 10 and the secondary heat source on the entire circuit board 1.

In addition, in the embodiment, the heat conducting member 120b (the runner pipe) is, for instance, a hollow copper pipe. Certainly, in other embodiments, the material of the runner pipe may be another thermally conductive metal material or another non-metallic thermally conductive material, which should not be construed as a limitation in the invention.

To sum up, the heat dissipation device provided in one or more embodiments of the invention includes the water cooling head module and the heat conducting member. The water cooling head module is thermally coupled to the primary heat source, one portion of the heat conducting member extends into the water cooling head module, and the other portion is thermally coupled to the secondary heat source. Thereby, the heat dissipation device provided in one or more embodiments of the invention dissipates heat from plural heat sources at the same time with use of one water cooling head module. In other words, the heat dissipation device provided in one or more embodiments of the invention may achieve heat dissipation effects within a limited space in a more efficient manner and may be more extensively applied. On the other hand, the fins provided in one or more embodiments of the invention may directly sleeve on the heat conducting member, or the heat dissipation fluid may flow to the secondary heat source through the fins, so that the water cooling head module provided herein may achieve favorable heat dissipation.

## Claims

1. A heat dissipation device (100,100a,100b) adapted to be disposed on a primary heat source (10) and a secondary heat source (50) and comprising:
a water cooling head module (110,110a,110b) disposed on the primary heat source (10); and
a heat conducting member (120,120a,120b) thermally coupled to the secondary heat source (50) and extending into the water cooling head module (110,110a,110b), the heat dissipation device (100,100a,100b) being **characterized in that**
the water cooling head module (110,110a,110b) has a water cooling tank (111), a water inlet (113), a water outlet (114) and a plurality of fins (112,112a) , the water inlet (113) and the water outlet (114) are respectively connected to the water cooling tank (111), the plurality of fins (112, 112a) extend along a first direction (D1) and arranged in parallel along a second direction (D2) in the water cooling tank (111),
the water cooling head module (110,110a,110b) comprises at least one side wall (115) and at least one inner partition board (116), the at least one side wall (115) extends along the first direction (D1) and is located on at least one side of the plurality of fins (112,112a), the at least one inner partition board (116) extends along the second direction (D2) and is connected to the at least one side wall (115) and at least one outermost fin of the plurality of fins (112,112a).

2. The heat dissipation device according to claim 1, wherein the water cooling head module (110,110a,11 0b) has a water cooling tank (111) and a plurality of fins (112,112a), the plurality of fins (112,112a) extend along a first direction (D1) and are arranged in parallel along a second direction (D2) in the water cooling tank (111), and the plurality of fins (112a) sleeve on one portion of the heat conducting member (120a) along the second direction (D2).

3. The heat dissipation device according to claim 2, wherein the heat conducting member (120a) comprises a heat pipe.

4. The heat dissipation device according to claim 1, wherein the at least one side wall (115) comprises two side walls (115), the at least one inner partition board (116) comprises two inner partition boards (116), the two side walls (115) extend along the first direction (D1) and are located on both sides of the plurality of fins (112,112a), the two inner partition boards (116) extend along the second direction (D2) and are connected to the two side walls (115) and two outermost fins (112,112a) of the plurality of fins (112,112a), the water inlet (113) is located at one side of a line connecting the two side walls (115), and the water outlet (114) is located at the other side of the line connecting the two side walls (115).

5. The heat dissipation device according to claim 1, wherein the water cooling tank (111) comprises a first region (1112) and a second region (1114), the water inlet (113) is connected to the first region (1112), the water outlet (114) is connected to the second region (1114), the plurality of fins (112, 112a) extend from the first region (1112) to the second region (1114), the heat conducting member (120,120a,120b) has a first terminal (122b), a second terminal (124b) opposite to the first terminal (122b), and a middle segment (126b) located between the first terminal (122b) and the second terminal (124b), the middle segment (126b) is thermally coupled to the secondary heat source (50), the first terminal (122b) extends into and communicates with the first region (1112) of the water cooling tank (111), and the second terminal (124b) extends into and communicates with the second region (1114) of the water cooling tank (111).

6. The heat dissipation device according to claim 5, wherein the heat conducting member (120,120a,120b) is a runner pipe, and an inner diameter of the first terminal (122b) is greater than an inner diameter of the second terminal (124b).

7. The heat dissipation device according to claim 1, further comprising a heat sink (130) disposed on the secondary heat source (50), the heat conducting member (120,120a,120b) being thermally coupled to the secondary heat source (50) through the heat sink (130).

8. The heat dissipation device according to claim 1, wherein the water cooling head module (110,110a,110b) further comprises a bottom plate (117) disposed on the primary heat source (10), and the heat conducting member (120,120a, 120b) contacts the bottom plate (117).

9. The heat dissipation device according to claim 1, wherein the water cooling head module (110,110a, 110b) further comprises a bottom plate (117) disposed on the primary heat source (10), and the heat conducting member (120,120a, 120b) is suspended from the bottom plate (117).

## Patentansprüche

1. Wärmeableitungsvorrichtung (100, 100a, 100b), die angepasst ist, um auf einer primären Wärmequelle (10) und einer sekundären Wärmequelle (50) angeordnet zu sein, und umfasst:
ein Wasserkühlkopfmodul (110, 110a, 110b), das an der primären Wärmequelle (10) angeordnet ist; und
ein Wärmeleitelement (120, 120a, 120b), das thermisch mit der sekundären Wärmequelle (50) gekoppelt ist und sich in das Wasserkühlkopfmodul (110, 110a, 110b) erstreckt, wobei die Wärmeableitungsvorrichtung (100, 100a, 100b) **dadurch gekennzeichnet ist, dass**
das Wasserkühlkopfmodul (110, 110a, 110b) einen Wasserkühltank (111), einen Wassereinlass (113), einen Wasserauslass (114) und eine Vielzahl von Rippen (112, 112a) aufweist, wobei der Wassereinlass (113) und der Wasserauslass (114) jeweils mit dem Wasserkühltank (111) verbunden sind, die Vielzahl von Rippen (112, 112a) sich entlang einer ersten Richtung (D1) erstreckt und parallel entlang einer zweiten Richtung (D2) in dem Wasserkühltank (111) angeordnet ist,
das Wasserkühlkopfmodul (110, 110a, 110b) mindestens eine Seitenwand (115) und mindestens eine innere Trennplatte (116) umfasst, sich die mindestens eine Seitenwand (115) entlang der ersten Richtung (D1) erstreckt und auf mindestens einer Seite der Vielzahl von Rippen (112, 112a) angeordnet ist, die mindestens eine innere Trennplatte (116) sich entlang der zweiten Richtung (D2) erstreckt und mit der mindestens einen Seitenwand (115) und mindestens einer äußersten Rippe der Vielzahl von Rippen (112, 112a) verbunden ist.

2. Wärmeableitungsvorrichtung gemäß Anspruch 1, wobei das Wasserkühlkopfmodul (110, 110a, 110b) einen Wasserkühltank (111) und eine Vielzahl von Rippen (112, 112a) aufweist, die Vielzahl von Rippen (112, 112a) sich entlang einer ersten Richtung (D1) erstreckt und parallel entlang einer zweiten Richtung (D2) in dem Wasserkühltank (111) angeordnet ist, und die Vielzahl von Rippen (112a) auf einem Abschnitt des Wärmeleitelements (120a) entlang der zweiten Richtung (D2) umhüllt ist.

3. Wärmeableitungsvorrichtung gemäß Anspruch 2, wobei das Wärmeleitelement (120a) ein Wärmerohr umfasst.

4. Wärmeableitungsvorrichtung gemäß Anspruch 1, wobei die mindestens eine Seitenwand (115) zwei Seitenwände (115) umfasst, die mindestens eine innere Trennplatte (116) zwei innere Trennplatten (116) umfasst, die beiden Seitenwände (115) sich entlang der ersten Richtung (D1) erstrecken und auf beiden Seiten der Vielzahl von Rippen (112, 112a) angeordnet sind, die beiden inneren Trennplatten (116) sich entlang der zweiten Richtung (D2) erstrecken und mit den beiden Seitenwänden (115) und den beiden äußersten Rippen (112, 112a) der Vielzahl von Rippen (112, 112a) verbunden sind, der Wassereinlass (113) sich auf einer Seite einer Linie befindet, die die beiden Seitenwände (115) verbindet, und der Wasserauslass (114) sich auf der anderen Seite der Linie befindet, die die beiden Seitenwände (115) verbindet.

5. Wärmeableitungsvorrichtung gemäß Anspruch 1, wobei der Wasserkühltank (111) einen ersten Bereich (1112) und einen zweiten Bereich (1114) umfasst, der Wassereinlass (113) mit dem ersten Bereich (1112) verbunden ist, der Wasserauslass (114) mit dem zweiten Bereich (1114) verbunden ist, die Vielzahl von Rippen (112, 112a) sich von dem ersten Bereich (1112) zu dem zweiten Bereich (1114) erstrecken, das Wärmeleitelement (120, 120a, 120b) einen ersten Anschluss (122b) , einen zweiten Anschluss (124b), der dem ersten Anschluss (122b) gegenüberliegt, und ein mittleres Segment (126b) aufweist, das sich zwischen dem ersten Anschluss (122b) und dem zweiten Anschluss (124b) befindet, wobei das mittlere Segment (126b) thermisch mit der sekundären Wärmequelle (50) gekoppelt ist, der erste Anschluss (122b) sich in den ersten Bereich (1112) des Wasserkühltanks (111) erstreckt und mit diesem kommuniziert, und der zweite Anschluss (124b) sich in den zweiten Bereich (1114) des Wasserkühltanks (111) erstreckt und mit diesem kommuniziert.

6. Wärmeableitungsvorrichtung gemäß Anspruch 5, wobei das Wärmeleitelement (120, 120a, 120b) ein Kanalrohr ist und ein Innendurchmesser des ersten Anschlusses (122b) größer ist als ein Innendurchmesser des zweiten Anschlusses (124b).

7. Wärmeableitungsvorrichtung gemäß Anspruch 1, die ferner eine Wärmesenke (130) umfasst, die an der sekundären Wärmequelle (50) angeordnet ist, wobei das Wärmeleitelement (120, 120a, 120b) über die Wärmesenke (130) thermisch mit der sekundären Wärmequelle (50) verbunden ist.

8. Wärmeableitungsvorrichtung gemäß Anspruch 1, wobei das Wasserkühlkopfmodul (110, 110a, 110b) ferner eine Bodenplatte (117) umfasst, die an der primären Wärmequelle (10) angeordnet ist, und das Wärmeleitelement (120, 120a, 120b) die Bodenplatte (117) berührt.

9. Wärmeableitungsvorrichtung gemäß Anspruch 1, wobei das Wasserkühlkopfmodul (110, 110a, 110b) ferner eine Bodenplatte (117) umfasst, die an der primären Wärmequelle (10) angeordnet ist, und das Wärmeleitelement (120, 120a, 120b) an der Bodenplatte (117) aufgehängt ist.

## Revendications

1. Dispositif de dissipation de chaleur (100, 100a, 100b) adapté pour être disposé sur une source de chaleur primaire (10) et une source de chaleur secondaire (50) et comprenant :
un module de tête de refroidissement par eau (110, 110a, 110b) disposé sur la source de chaleur primaire (10); et
un élément conducteur de chaleur (120, 120a, 120b) couplé thermiquement à la source de chaleur secondaire (50) et s'étendant dans le module de tête de refroidissement par eau (110, 110a, l10b), le dispositif de dissipation de chaleur (100, 100a, 100b) étant **caractérisé en ce que**
le module de tête de refroidissement par eau (110, 110a, 110b) comporte un réservoir de refroidissement par eau (111), une entrée d'eau (113), une sortie d'eau (114) et une pluralité d'ailettes (112, 112a), l'entrée d'eau (113) et la sortie d'eau (114) sont respectivement reliées au réservoir de refroidissement d'eau (111), la pluralité d'ailettes (112, 112a) s'étendent le long d'une première direction (D1) et sont agencées en parallèle le long d'une deuxième direction (D2) dans le réservoir de refroidissement par eau (111),
le module de tête de refroidissement par eau (110, 110a, 110b) comprend au moins une paroi latérale (115) et au moins une cloison intérieure (116), la au moins une paroi latérale (115) s'étend le long de la première direction (D1) et est située sur au moins un côté de la pluralité d'ailettes (112, 112a), la au moins une cloison intérieure (116) s'étend le long de la deuxième direction (D2) et est reliée à la au moins une paroi latérale (115) et au moins une ailette la plus à l'extérieur de la pluralité d'ailettes (112, 112a).

2. Dispositif de dissipation thermique selon la revendication 1, dans lequel le module de tête de refroidissement par eau (110, 110a, 110b) comporte un réservoir de refroidissement par eau (111) et une pluralité d'ailettes (112, 112a), la pluralité d'ailettes (112, 112a) s'étendent le long d'une première direction (D1) et sont disposées parallèlement selon une deuxième direction (D2) dans le réservoir de refroidissement d'eau (111), et la pluralité d'ailettes (112a) s'emmanchent sur une partie de l'élément conducteur de chaleur (120a) le long de la deuxième direction (D2).

3. Dispositif de dissipation de chaleur selon la revendication 2, dans lequel l'élément conducteur de chaleur (120a) comprend un caloduc.

4. Dispositif de dissipation thermique selon la revendication 1, dans lequel la au moins une paroi latérale (115) comprend deux parois latérales (115), la au moins une cloison intérieure (116) comprend deux cloisons intérieures (116), les deux parois latérales (115) s'étendent le long de la première direction (D1) et sont situées des deux côtés de la pluralité d'ailettes (112, 112a), les deux cloisons intérieures (116) s'étendent le long de la deuxième direction (D2) et sont raccordées aux deux parois latérales (115) et aux deux ailettes les plus à l'extérieur (112, 112a) de la pluralité d'ailettes (112, 112a), l'entrée d'eau (113) est située d'un côté d'une ligne reliant les deux parois latérales (115), et la sortie d'eau (114) est située de l'autre côté de la ligne reliant les deux parois latérales (115).

5. Dispositif de dissipation thermique selon la revendication 1, dans lequel le réservoir de refroidissement d'eau (111) comprend une première région (1112) et une deuxième région (1114), l'entrée d'eau (113) est raccordée à la première région (1112), la sortie d'eau (114) est reliée à la deuxième région (1114), la pluralité d'ailettes (112, 112a) s'étendent de la première région (1112) à la deuxième région (1114), l'élément conducteur de chaleur (120, 120a, 120b) comporte une première borne (122b), une deuxième borne (124b) opposée à la première borne (122b), et un segment médian (126b) situé entre la première borne (122b) et la deuxième borne (124b), le segment médian (126b) est couplé thermiquement à la source de chaleur secondaire (50), la première borne (122b) s'étend dans et communique avec la première région (1112) du réservoir de refroidissement d'eau (111), et la deuxième borne (124b) s'étend dans et communique avec la deuxième région (1114) du réservoir de refroidissement d'eau (111).

6. Dispositif de dissipation thermique selon la revendication 5, dans lequel l'élément conducteur de chaleur (120, 120a, 120b) est un tuyau de guidage, et un diamètre intérieur de la première borne (122b) est supérieur à un diamètre intérieur de la deuxième borne (124b).

7. Dispositif de dissipation thermique selon la revendication 1, comprenant en outre un dissipateur thermique (130) disposé sur la source de chaleur secondaire (50), l'élément conducteur de chaleur (120, 120a, 120b) étant couplé thermiquement à la source de chaleur secondaire (50) par l'intermédiaire du dissipateur thermique (130).

8. Dispositif de dissipation thermique selon la revendication 1, dans lequel le module de tête de refroidissement par eau (110, 110a, 1 10b) comprend en outre une plaque de fond (117) disposée sur la source de chaleur primaire (10), et l'élément conducteur de chaleur (120, 120a, 120b) contacte la plaque inférieure (117).

9. Dispositif de dissipation thermique selon la revendication l, dans lequel le module de tête de refroidissement par eau (110, 110a, 1 10b) comprend en outre une plaque inférieure (117) disposée sur la source de chaleur primaire (10), et l'élément conducteur de chaleur (120, 120a, 120b) est suspendu à la plaque inférieure (117).
